# FASCICULE DE BREVET EUROPEEN

(11) **EP 3 435 750 B1**
(45) Date de publication et mention de la délivrance du brevet: **03.03.2021**
(21) Numéro de dépôt: 18178164.2
(22) Date de dépôt: 18.06.2018
(51) Int. Cl.: H05K 7/20

(54) **DISPOSITIF POUR SUPPORTER ET CONNECTER DES CARTES ÉLECTRONIQUES COMPRENANT UN GUIDE DE CARTES ÉLECTRONIQUES QUI PRÉSENTE DES PROPRIÉTÉS THERMIQUES AMELIORÉES**
HALTERUNGS- UND ANSCHLUSSVORRICHTUNG FÜR ELEKTRONISCHE KARTEN, WELCHE EINE FÜHRUNG FÜR ELEKTRONISCHE KARTEN UMFASST, DIE VERBESSERTE THERMISCHE EIGENSCHAFTEN AUFWEIST
DEVICE FOR SUPPORTING AND CONNECTING ELECTRONIC CARDS COMPRISING AN ELECTRONIC CARD GUIDE WITH IMPROVED THERMAL PROPERTIES

(30) Priorité: 27.07.2017 FR 1757129
(43) Date de publication de la demande: 30.01.2019
(73) Titulaire: Airbus Operations (S.A.S.), 31060 Toulouse (FR)
(72) Inventeur: SIBONI, Laurent, 31490 LEGUEVIN (FR); BACHY, Emmanuel, 35580 GOVEN (FR); DUPONT, Vincent, 1160 AUDERGHEM (BE)
(74) Mandataire: Gicquel, Olivier Yves Gérard

(56) Documents cités:
- EP-A1- 2 421 350
- EP-A1- 2 448 390
- FR-A1- 3 001 603
- FR-A1- 3 037 210

## Description

La présente demande se rapporte à un dispositif pour supporter et connecter des cartes électroniques comprenant un guide de cartes électroniques qui présente des propriétés thermiques améliorées.

Dans le domaine aéronautique, il existe des dispositifs qui sont configurés pour supporter des cartes électroniques 10 et permettre leur connexion. De tels dispositifs sont à titre d'exemples divulgués dans les documents EP2421350, FR3001603, EP2448390 et FR3037210. Selon un mode de réalisation visible sur la figure 3, une carte électronique 10 est une plaque sur laquelle sont rapportés des composants électriques et/ou électroniques, la plaque ayant une forme approximativement carrée ou rectangulaire et présentant un premier bord 12 sur lequel est positionnée au moins une connexion 14 et des deuxième et troisième bords 16, 16' configurés pour guider la carte électronique 10.

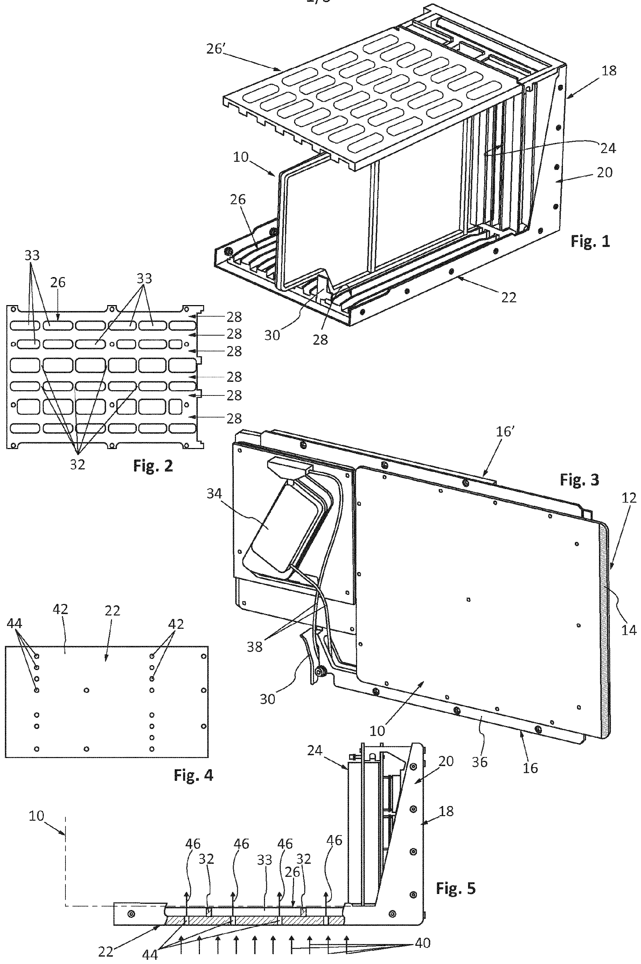

Selon un mode de réalisation connu et illustré par la figure 1, un dispositif pour supporter et connecter des cartes électroniques 10 comprend :
- un support de cartes électroniques 18 en forme de L, qui présente une première aile 20 approximativement verticale et une deuxième aile 22 approximativement horizontale,
- des connecteurs 24 positionnés sur la première aile 20 du support de cartes électroniques 18, au moins un pour chaque carte électronique 10, chacun étant configuré pour recevoir la connexion 14 d'une carte électronique 10,
- un guide de cartes électroniques 26 qui est positionné et fixé sur la deuxième aile 22 du support de cartes électroniques 18 et qui est configuré pour guider chaque carte électronique 10 en direction du connecteur 24 qui lui est associé.

Selon un mode de réalisation visible sur la figure 1, le dispositif pour supporter et connecter des cartes électroniques 10 comprend un premier guide de cartes électroniques 26 qui est positionné et fixé sur la deuxième aile 22 du support de cartes électroniques 18 ainsi qu'un deuxième guide de cartes électroniques 26' parallèle au premier guide de cartes électroniques 26, les cartes électroniques 10 étant intercalées entre les premier et deuxième guides de cartes électroniques 26 et 26'.

Chaque guide de cartes électroniques 26, 26' comprend plusieurs rainures 28, une pour chaque carte électronique 10, chaque rainure 28 ayant une section en U configurée pour loger le deuxième ou troisième bord 16, 16' de la carte électronique 10 et assurer un guidage de la carte électronique 10 selon une direction perpendiculaire à la première aile 20 du support de cartes électroniques 18 qui correspond à la direction d'insertion de la carte électronique 10.

Pour chaque carte électronique 10, au moins l'un des guides de cartes électroniques 26, 26' et/ou la carte électronique 10 comprend un système de blocage 30 permettant d'immobiliser la carte électronique 10 et d'empêcher le retrait de la connexion 14 de la carte du connecteur 24 associé.

Le guide de cartes électroniques 26 comprend une pluralité de fines bandes de matière 32 qui relient les rainures 28 et qui s'étendent perpendiculairement à la direction des rainures 28.

Comme illustré sur la figure 3, au moins une carte électronique 10 comprend un système de captage 34 de la chaleur de la carte électronique 10, un dissipateur 36 positionné au niveau du deuxième bord 16 de la carte électronique 10 et un caloduc 38 permettant d'acheminer la chaleur du système de captage 34 vers le dissipateur 36.

Selon ce mode de réalisation, la chaleur émise par la carte électronique 10 est transmise par le dissipateur 36 vers le guide de cartes électroniques 26 puis vers le support de cartes électroniques 18 qui est alors utilisé pour dissiper la chaleur.

Le dispositif pour supporter et connecter des cartes électroniques 10 comprend également un système de distribution d'un premier flux d'air 40 pour réguler la température des cartes électroniques 10. Ce système de distribution permet également d'assurer une chute de pression communément appelée perte de charge.

Selon un mode de réalisation visible sur les figures 4 et 5, la deuxième aile 22 du support de cartes électroniques 10 se présente sous la forme d'une plaque pleine 42.

Le système de distribution du premier flux d'air comprend une pluralité d'orifices 44 qui traversent la plaque pleine 42. Ces orifices 44 sont agencés et dimensionnés pour distribuer le premier flux d'air 40 provenant de dessous la deuxième aile 22 et la traversant en au moins un deuxième flux d'air 46 au-dessus de la deuxième aile 22 et au contact des cartes électroniques 10. Ces orifices 44 de la deuxième aile 22 du support de cartes électroniques 18 ont des sections inférieures aux trous 33 délimités par les rainures 28 et les fines bandes de matière 32 du guide de cartes électroniques 26.

Pour ne pas perturber le système de distribution du premier flux d'air, les fines bandes de matière 32 du guide de cartes électroniques 26 sont espacées d'une distance importante pour laisser passer sans restriction l'air à travers le guide de cartes électroniques 26 et ont une faible hauteur (dimension prise selon une direction perpendiculaire à la deuxième aile 22) par rapport à la hauteur des branches de la section en U des rainures 28.

Par conséquent, les capacités du guide de cartes électroniques 26 à dissiper la chaleur ne sont pas optimales.

Par ailleurs, les surfaces de contact entre le guide de cartes électroniques 26 et le support de cartes électroniques 18 étant réduites, le transfert de la chaleur entre le guide de cartes électroniques 26 et le support de cartes électroniques 18 est limité ce qui réduit la capacité à dissiper la chaleur en provenance du caloduc 38.

La présente invention vise à remédier aux inconvénients de l'art antérieur.

A cet effet, l'invention a pour objet un dispositif pour supporter et connecter des cartes électroniques comprenant :
- un support de cartes électroniques en forme de L, qui présente une première aile et une deuxième aile qui est approximativement perpendiculaire à la première aile et qui comprend une plaque pleine qui présente au moins une ouverture,
- des connecteurs positionnés sur la première aile du support de cartes électroniques, au moins un pour chaque carte électronique, chacun étant configuré pour recevoir une connexion d'une carte électronique,
- au moins un guide de cartes électroniques positionné et fixé sur la deuxième aile du support de cartes électroniques, comportant plusieurs rainures, une pour chaque carte électronique, chaque rainure étant configurée pour guider une carte électronique selon une direction d'insertion en direction du connecteur qui lui est associé,
- un système de distribution d'un premier flux d'air provenant de dessous le support de cartes électroniques et traversant la deuxième aile du support de cartes électroniques et le guide de cartes électroniques pour réguler la température des cartes électroniques.

Selon l'invention, le guide de cartes électroniques est en un matériau métallique et comprend des parois pour relier les rainures qui sont pleines et recouvrent la ou les ouverture(s) du support de cartes électroniques ; le système de distribution comprend une pluralité de fentes qui traversent au moins une paroi du guide de cartes électroniques, qui sont séparées par des ailettes et regroupées de manière à former au moins une zone d'échange thermique, qui présentent chacune une section inférieure à celle de chaque ouverture du support de cartes électroniques et qui sont agencées et dimensionnées pour distribuer le premier flux d'air en au moins un deuxième flux d'air au-dessus du guide de cartes électroniques et au contact des cartes électroniques.

Par rapport à l'art antérieur, le guide de cartes électroniques qui correspond à l'élément du dispositif pour supporter et connecter des cartes électroniques directement en contact avec les cartes électroniques comprend des surfaces en contact avec le premier flux d'air importantes ce qui favorise la dissipation de la chaleur émise par les cartes électroniques dans le premier flux d'air.

Selon une autre caractéristique, chaque fente a une hauteur supérieure ou égale à la hauteur maximale du guide de cartes électroniques.

Selon une autre caractéristique, les fentes sont orientées selon une direction perpendiculaire à la direction d'insertion.

Selon une configuration, chaque fente a une longueur comprise entre 5 et 15 mm et une largeur comprise entre 0,5 et 1,5 mm et/ou chaque ailette a une épaisseur comprise entre 0,5 et 2 mm.

Selon un premier mode de réalisation, les fentes sont perpendiculaires à la deuxième aile du support de cartes électroniques.

Selon un autre mode de réalisation, les fentes sont inclinées par rapport à la deuxième aile du support de cartes électroniques.

Selon un agencement, la ou les zone(s) d'échange thermique jouxte(nt) au moins une rainure recevant une carte électronique équipée d'un caloduc.

D'autres caractéristiques et avantages ressortiront de la description de l'invention qui va suivre, description donnée à titre d'exemple uniquement, en regard des dessins annexés parmi lesquels :
- La figure 1 est une vue en perspective d'un dispositif pour supporter et connecter des cartes électroniques 10 qui illustre un mode de réalisation de l'art antérieur,
- La figure 2 est une vue de dessus d'un guide de cartes électroniques qui illustre un mode de réalisation de l'art antérieur,
- La figure 3 est une vue en perspective d'une carte électronique équipée d'un caloduc,
- La figure 4 est une vue de dessus d'une partie d'un support de cartes électroniques qui illustre un mode de réalisation de l'art antérieur,
- La figure 5 est une vue latérale d'un support de cartes électroniques avec une coupe partielle qui illustre un mode de réalisation de l'art antérieur,
- La figure 6 est une vue en perspective d'un dispositif pour supporter et connecter des cartes électroniques 10 qui illustre un mode de réalisation de l'invention,
- La figure 7 est une vue en perspective d'une carte électronique équipée d'un caloduc,
- La figure 8 est une vue en perspective d'un support de cartes électroniques qui illustre un mode de réalisation de l'invention,
- La figure 9 est une vue en perspective d'un guide de cartes électroniques qui illustre un mode de réalisation de l'invention,
- La figure 10 est une vue de dessus du guide de cartes électroniques visible sur la figure 9,
- La figure 11 est une vue de dessus d'une partie du guide de cartes électroniques visible sur la figure 9,
- La figure 12A est une coupe selon la ligne XII-XII de la figure 10 qui illustre un premier mode de réalisation de l'invention,
- La figure 12B est une coupe selon la ligne XII-XII de la figure 10 qui illustre un autre mode de réalisation de l'invention, et
- La figure 13 est une coupe selon la ligne XIII-XIII de la figure 10.

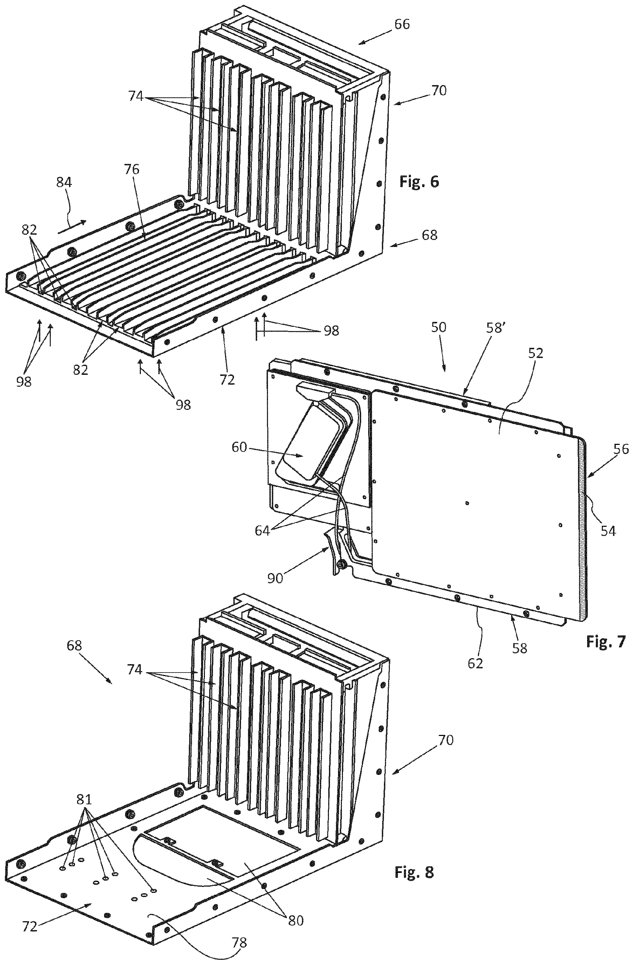

Selon un mode de réalisation visible sur la figure 7, une carte électronique 50 comprend une plaque 52 sur laquelle sont rapportés des composants électriques et/ou électroniques, la plaque 52 ayant une forme approximativement carrée ou rectangulaire et présentant un premier bord 54 sur lequel est positionnée au moins une connexion 56 et un deuxième bord 58, approximativement perpendiculaire au premier bord 54, configuré pour guider la carte électronique 50. La carte électronique 50 peut comprendre un troisième bord 58', parallèle au deuxième bord 58.

La carte électronique 50 comprend un système de captage 60 de la chaleur de la carte électronique 50, un dissipateur 62 positionné au niveau du deuxième bord 58 de la carte électronique 50 et un caloduc 64 permettant d'acheminer la chaleur du système de captage 60 vers le dissipateur 62. Selon une configuration, le dissipateur 62 est un drain qui s'étend le long du deuxième bord 58 de la carte électronique 50.

Selon un mode de réalisation, un dispositif 66 pour supporter et connecter des cartes électroniques 50 comprend :
- un support de cartes électroniques 68 en forme de L, qui présente une première aile 70 et une deuxième aile 72 approximativement perpendiculaire à la première aile 70 qui est généralement verticale,
- des connecteurs 74 positionnés sur la première aile 70 du support de cartes électroniques 68, au moins un pour chaque carte électronique 50, chacun étant configuré pour recevoir la connexion 56 d'une carte électronique 50,
- au moins un guide de cartes électroniques 76 positionné et fixé sur la deuxième aile 72 du support de cartes électroniques 68 et configuré pour guider chaque carte électronique 50 en direction du connecteur 74 qui lui est associé.

Selon un mode de réalisation non représenté, le dispositif pour supporter et connecter des cartes électroniques 66 comprend un premier guide de cartes électroniques 76 qui est positionné et fixé sur la deuxième aile 22 du support de cartes électroniques 18 ainsi qu'un deuxième guide de cartes électroniques parallèle au premier guide de cartes électroniques 26, les cartes électroniques 10 étant intercalées entre les premier et deuxième guides de cartes électroniques.

Selon un mode de réalisation, le support de cartes électroniques 68 est métallique. Sa deuxième aile 72 comprend une plaque pleine 78 qui présente au moins une large ouverture 80. Par large ouverture, on entend que l'ouverture 80 n'a pas de fonction de distribution d'un flux d'air.

La deuxième aile 72 du support de cartes électroniques 68 peut comprendre des orifices 81 configurés pour assurer la fonction de distribution d'un flux d'air à la manière des orifices 44 prévus sur la deuxième aile d'un support de cartes électroniques de l'art antérieur.

Selon un mode de réalisation, le guide de cartes électroniques 76 comprend plusieurs rainures 82, une pour chaque carte électronique 50, chaque rainure 82 ayant une section en U adaptée pour loger le deuxième bord 58 de la carte électronique 50 et assurer un guidage de la carte électronique 50 selon une direction d'insertion 84 de la carte électronique 50 perpendiculaire à la première aile 70 du support de carte électroniques 66.

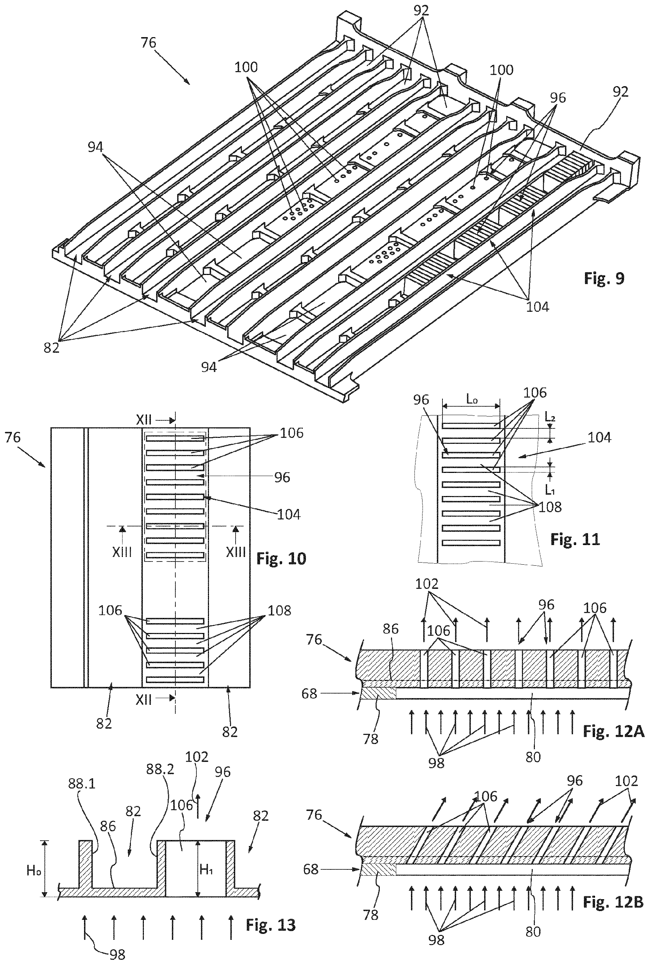

Comme illustré sur la figure 13, chaque rainure 82 est délimitée par un fond 86 et deux parois latérales 88.1 et 88.2. Pour assurer le guidage d'une carte électronique 50, le guide de cartes électroniques 76 a une hauteur H₀ au niveau des parois latérales de l'ordre de 10 mm ou plus.

Pour chaque carte électronique 50, le guide de cartes électroniques 76 et/ou la carte électronique 50 comprend un système de blocage 90 permettant d'immobiliser la carte électronique 50 et d'empêcher le retrait de la connexion 56 de la carte électronique 50 du connecteur 74 associé.

Le guide de cartes électroniques 76 comprend des parois 92 pour relier les rainures 82. Ces parois 92 sont pleines et recouvrent la ou les ouverture(s) 80 du support de cartes électroniques 68 lorsque le guide de cartes électroniques 76 est fixé sur la deuxième aile 72 du support de cartes électroniques 68. Les parois 92 peuvent présenter des ouvertures 94 dans des zones superposées à la plaque 78 formant la deuxième aile 72 et ne présentant pas le ou les ouverture(s) 80. Ces ouvertures 94, à la manière des trous 33 prévus sur le guide de cartes électroniques de l'art antérieur, n'assurent pas la fonction de distribution d'un flux d'air.

Selon un mode de réalisation, le guide de cartes électroniques 76 est en un matériau métallique combinant une conductivité thermique élevée et une faible densité. Le guide de cartes électroniques 76 est en alliage d'aluminium.

Le dispositif 66 pour supporter et connecter des cartes électroniques 50 comprend également un système de distribution 96 d'un premier flux d'air 98 traversant la deuxième aile 72 du support de cartes électroniques 68 et le guide de cartes électroniques 76 pour réguler la température des cartes électroniques 50.

Selon une caractéristique de l'invention, le système de distribution 96 comprend une pluralité de trous 100 qui traversent au moins une paroi 92 et qui sont agencés et dimensionnés pour distribuer le premier flux d'air 98, provenant de dessous le support de cartes électroniques 68 et traversant le support de cartes électroniques 68 et le guide de cartes électroniques 76, en au moins un deuxième flux d'air 102 au-dessus du guide de cartes électroniques 76 et au contact des cartes électroniques 50. Les trous 100 du guide de cartes électroniques 76 coopèrent avec au moins une ouverture 80 prévue au niveau de la deuxième aile 72 du support de cartes électroniques 68, ladite ouverture 80 présentant une section supérieure à chaque trou 100 du guide de cartes électroniques 76. Pour assurer la fonction de distribution, chaque trou 100 a une section de passage inférieure à celle de chacune des ouvertures 80.

Selon certains modes de réalisation, le système de distribution 96 peut comprendre, en complément des trous 100, des orifices 81 traversant la deuxième aile 72 du support de cartes électroniques 68 qui sont agencés et dimensionnés pour distribuer le premier flux d'air 98 et qui coopèrent avec au moins une ouverture 94 prévue au niveau du guide de cartes électroniques 76, ladite ouverture 94 présentant une section supérieure à chaque orifice 81. Le système de distribution est dimensionné pour obtenir une perte de charge adaptée.

Selon l'invention, le guide de cartes électroniques 76 qui correspond à l'élément du dispositif 66 pour supporter et connecter des cartes électroniques 50 directement en contact avec le dissipateur 62 de chaque carte électronique 50, assure la fonction de distribution du premier flux d'air 98 et comprend des surfaces de contact avec le premier flux d'air 98 plus importantes que celles de l'art antérieur ce qui favorise la dissipation de la chaleur émise par les cartes électroniques 50 dans le premier flux d'air 98.

Ainsi, selon l'invention, le guide de cartes électroniques 76 assure la fonction d'échangeur thermique pour dissiper la chaleur acheminée par le ou les caloduc(s) 64 dans le premier flux 98.

Selon une caractéristique de l'invention, au moins certains trous 100 se présentent sous la forme de fentes 106 qui sont regroupées et séparées par des ailettes 108 de faible épaisseur de manière à former au moins une zone d'échange thermique 104. Cette configuration permet d'augmenter la densité des surfaces d'échange thermique entre le guide de cartes électroniques 76 et le premier flux d'air 98 et, in fine, d'augmenter la capacité de refroidissement.

Par faible épaisseur, on entend que les ailettes 108 ont une épaisseur L₂ (dimension mesurée selon une direction perpendiculaire à l'orientation des fentes 106) inférieure à 4 mm.

Selon une configuration, ces fentes 106 sont orientées selon une direction perpendiculaire à la direction d'insertion 84.

Selon une configuration, la ou les zone(s) d'échange thermique 104 jouxte(nt) au moins une rainure 82 recevant une carte électronique 50 équipée d'un caloduc 64.

Pour donner un ordre de grandeur, chaque fente 106 a une longueur L₀ (dimension mesurée selon une direction perpendiculaire à la direction d'insertion 84) comprise entre 5 et 15 mm, de préférence de l'ordre de 10 à 12 mm, une largeur L₁ (dimension mesurée selon une direction parallèle à la direction d'insertion 84) comprise entre 0,5 et 1,5 mm, de préférence comprise entre 0,5 et 0,8 mm. Les ailettes 108 ont une épaisseur L₂ (dimension mesurée selon une direction parallèle à la direction d'insertion 84) comprise entre 0,5 et 2 mm, de préférence de l'ordre de 1 mm.

Le dimensionnement des fentes 106 et des ailettes 108 est spécifique d'un dispositif 66 à l'autre en fonction de la quantité de chaleur à dissiper.

Selon une autre caractéristique, chaque fente 106 a une hauteur H1 (dimension prise entre les extrémités de la fente 106) supérieure ou égale à la hauteur H₀ maximale du guide de cartes électroniques 76 au niveau des parois 88.1 et 88.2 des rainures 82.

Cette solution permet d'augmenter la surface des fentes 106 en contact avec le premier flux d'air 98.

Selon un premier mode de réalisation visible sur la figure 12A, les fentes 106 sont perpendiculaires à la deuxième aile 72 du support de cartes électroniques 68. Ainsi, elles sont orientées parallèlement au premier flux d'air 98 et ne le dévient pas.

Selon un deuxième mode de réalisation visible sur la figure 12B, les fentes 106 sont inclinées par rapport à la deuxième aile 72 du support de cartes électroniques 68. Selon cette configuration, le premier flux d'air 98 est dévié.

Le guide de cartes électroniques 76 peut être réalisé par usinage ou par fabrication additive.

## Revendications

1. Dispositif pour supporter et connecter des cartes électroniques (50) comprenant :
- un support de cartes électroniques (68) en forme de L, qui présente une première aile (70) et une deuxième aile (72) qui est approximativement perpendiculaire à la première aile (70) et qui comprend une plaque pleine (78) qui présente au moins une ouverture (80),
- des connecteurs (74) positionnés sur la première aile (70) du support de cartes électroniques (68), au moins un pour chaque carte électronique (50), chacun étant configuré pour recevoir une connexion (56) d'une carte électronique (50),
- au moins un guide de cartes électroniques (76) positionné et fixé sur la deuxième aile (72) du support de cartes électroniques (68), comportant plusieurs rainures (82), une pour chaque carte électronique (50), chaque rainure (82) étant configurée pour guider une carte électronique (50) selon une direction d'insertion (84) en direction du connecteur (74) qui lui est associé,
- un système de distribution (96) d'un premier flux d'air (98) provenant de dessous le support de cartes électroniques (68) et traversant la deuxième aile (72) du support de cartes électroniques (68) et le guide de cartes électroniques (76) pour réguler la température des cartes électroniques (50),
le guide de cartes électroniques (76) étant en un matériau métallique et
comprenant des parois (92) pour relier les rainures (82) qui sont pleines et recouvrent la ou les ouverture(s) (80) du support de cartes électroniques (68) et le système de distribution (96) comprenant une pluralité de fentes (106) qui traversent au moins une paroi (92) du guide de cartes électroniques (76), qui sont séparées par des ailettes (108) et regroupées de manière à former au moins une zone d'échange thermique (104), qui présentent chacune une section inférieure à celle de chaque ouverture (80) du support de cartes électroniques (68) et qui sont agencées et dimensionnées pour distribuer le premier flux d'air (98) en au moins un deuxième flux d'air (102) au-dessus du guide de cartes électroniques (76) et au contact des cartes électroniques (50).

2. Dispositif pour supporter et connecter des cartes électroniques (50) selon la revendication 1, **caractérisé en ce que** chaque fente (106) a une hauteur (H1) supérieure ou égale à la hauteur maximale du guide de cartes électroniques (76).

3. Dispositif pour supporter et connecter des cartes électroniques (50) selon la revendication 1 ou 2, **caractérisé en ce que** les fentes (106) sont orientées selon une direction perpendiculaire à la direction d'insertion (84).

4. Dispositif pour supporter et connecter des cartes électroniques (50) selon l'une des revendications précédentes, **caractérisé en ce que** chaque fente (106) a une longueur comprise entre 5 et 15 mm et une largeur comprise entre 0,5 et 1,5 mm.

5. Dispositif pour supporter et connecter des cartes électroniques (50) selon l'une des revendications précédentes, **caractérisé en ce que** chaque ailette (108) a une épaisseur (L₂) comprise entre 0,5 et 2 mm.

6. Dispositif pour supporter et connecter des cartes électroniques (50) selon l'une des revendications précédentes, **caractérisé en ce que** les fentes (106) sont perpendiculaires à la deuxième aile (72) du support de cartes électroniques (68).

7. Dispositif pour supporter et connecter des cartes électroniques (50) selon l'une des revendications 1 à 5, **caractérisé en ce que** les fentes (106) sont inclinées par rapport à la deuxième aile (72) du support de cartes électroniques (68).

8. Dispositif pour supporter et connecter des cartes électroniques (50) selon l'une des revendications précédentes, **caractérisé en ce que** la ou les zone(s) d'échange thermique (104) jouxte(nt) au moins une rainure (82) recevant une carte électronique (50) équipée d'un caloduc (64).

## Patentansprüche

1. Vorrichtung zum Tragen und Anschließen von Platinen (50), umfassend:
- einen Platinenträger (68) in L-Form, der einen ersten Flügel (70) und einen zweiten Flügel (72), der ungefähr senkrecht zum ersten Flügel (70) verläuft und eine massive Platte (78) mit mindestens einer Öffnung (80) umfasst, aufweist,
- Verbinder (74), die auf dem ersten Flügel (70) des Platinenträgers (68) positioniert sind, mindestens einer für jede Platine (50), wobei jeder dazu ausgebildet ist, einen Anschluss (56) einer Platine (50) aufzunehmen,
- mindestens eine Platinenführung (76), die auf dem zweiten Flügel (72) des Platinenträgers (68) positioniert und befestigt ist, die mehrere Rillen (82) aufweist, eine für jede Platine (50), wobei jede Rille (82) dazu ausgebildet ist, eine Platine (50) in einer Einführrichtung (84) in Richtung des Verbinders (74), der ihr zugeordnet ist, zu führen,
- ein System zur Verteilung (96) eines ersten Luftstroms (98), der von unterhalb des Platinenträgers (68) kommt und den zweiten Flügel (72) des Platinenträgers (68) und die Platinenführung (76) durchquert, um die Temperatur der Platinen (50) zu regeln, wobei die Platinenführung (76) aus einem Metallmaterial ist und Wände (92) umfasst, um die Rillen (82) zu verbinden, die massiv sind und die Öffnung(en) (80) des Platinenträgers (68) abdecken, und das Verteilungssystem (96) eine Mehrzahl von Schlitzen (106) umfasst, die durch mindestens eine Wand (92) der Platinenführung (76) hindurchgehen, die durch Rippen (108) getrennt sind und so gruppiert sind, dass sie mindestens einen Wärmeaustauschbereich (104) bilden, die jeweils einen Abschnitt unter dem jeder Öffnung (80) des Platinenträgers (68) aufweisen und angeordnet und bemessen sind, den ersten Luftstrom (98) in mindestens einem zweiten Luftstrom (102) über der Platinenführung (76) und in Kontakt mit den Platinen (50) zu verteilen.

2. Vorrichtung zum Tragen und Anschließen von Platinen (50) nach Anspruch 1, **dadurch gekennzeichnet, dass** jeder Schlitz (106) eine Höhe (H1) größer als oder gleich der maximalen Höhe der Platinenführung (76) aufweist.

3. Vorrichtung zum Tragen und Anschließen von Platinen (50) nach Anspruch 1 oder 2, **dadurch gekennzeichnet, dass** die Schlitze (106) in einer Richtung senkrecht zur Einführrichtung (84) ausgerichtet sind.

4. Vorrichtung zum Tragen und Anschließen von Platinen (50) nach einem der vorhergehenden Ansprüche, **dadurch gekennzeichnet, dass** jeder Schlitz (106) eine Länge zwischen 5 und 15 mm und eine Breite zwischen 0,5 und 1,5 mm aufweist.

5. Vorrichtung zum Tragen und Anschließen von Platinen (50) nach einem der vorhergehenden Ansprüche, **dadurch gekennzeichnet, dass** jede Rippe (108) eine Dicke (L₂) zwischen 0,5 mm und 2 mm aufweist.

6. Vorrichtung zum Tragen und Anschließen von Platinen (50) nach einem der vorhergehenden Ansprüche, **dadurch gekennzeichnet, dass** die Schlitze (106) senkrecht zum zweiten Flügel (72) des Platinenträgers (68) verlaufen.

7. Vorrichtung zum Tragen und Anschließen von Platinen (50) nach einem der Ansprüche 1 bis 5, **dadurch gekennzeichnet, dass** die Schlitze (106) bezogen auf den zweiten Flügel (72) des Platinenträgers (68) geneigt sind.

8. Vorrichtung zum Tragen und Anschließen von Platinen (50) nach einem der vorhergehenden Ansprüche, **dadurch gekennzeichnet, dass** der bzw. die Wärmeaustauschbereich(e) (104) an mindestens eine Rille (82) angrenzt bzw. angrenzen, die eine Platine (50) aufnimmt, die mit einem Wärmerohr (64) ausgerüstet ist.

## Claims

1. Device for supporting and connecting electronic circuit boards (50) comprising:
- an L-shaped electronic circuit board support (68), which has a first wing (70) and a second wing (72) which is approximately at right angles to the first wing (70) and which comprises a solid plate (78) which has at least one aperture (80),
- connectors (74) positioned on the first wing (70) of the electronic circuit board support (68), at least one for each electronic circuit board (50), each being configured to receive a connection (56) of an electronic circuit board (50),
- at least one electronic circuit board guide (76) positioned and fixed on the second wing (72) of the electronic circuit board support (68), comprising several grooves (82), one for each electronic circuit board (50), each groove (82) being configured to guide an electronic circuit board (50) in a direction of insertion (84) towards the connector (74) which is associated with it,
- a system (96) for distributing a first air flow (98) originating from below the electronic circuit board support (68) and passing through the second wing (72) of the electronic circuit board support (68) and the electronic circuit board guide (76) to regulate the temperature of the electronic circuit boards (50),
the electronic circuit board guide (76) being made of a metallic material and comprising walls (92) for linking the grooves (82) which are solid and cover the aperture or apertures (80) of the electronic circuit board support (68) and the distribution system (96) comprising a plurality of slits (106) which pass through at least one wall (92) of the electronic circuit board guide (76), which are separated by fins (108) and grouped together so as to form at least one heat exchange zone (104), each of which has a section smaller than that of each aperture (80) of the electronic circuit board support (68) and which are arranged and dimensioned to distribute the first air flow (98) as at least one second air flow (102) above the electronic circuit board guide (76) and in contact with the electronic circuit boards (50).

2. Device for supporting and connecting electronic circuit boards (50) according to Claim 1, **characterized in that** each slit (106) has a height (H1) greater than or equal to the maximum height of the electronic circuit board guide (76).

3. Device for supporting and connecting electronic circuit boards (50) according to Claim 1 or 2, **characterized in that** the slits (106) are oriented in a direction at right angles to the direction of insertion (84).

4. Device for supporting and connecting electronic circuit boards (50) according to one of the preceding claims, **characterized in that** each slit (106) has a length of between 5 and 15 mm and a width of between 0.5 and 1.5 mm.

5. Device for supporting and connecting electronic circuit boards (50) according to one of the preceding claims, **characterized in that** each fin (108) has a thickness (L₂) of between 0.5 and 2 mm.

6. Device for supporting and connecting electronic circuit boards (50) according to one of the preceding claims, **characterized in that** the slits (106) are at right angles to the second wing (72) of the electronic circuit board support (68).

7. Device for supporting and connecting electronic circuit boards (50) according to one of Claims 1 to 5, **characterized in that** the slits (106) are inclined with respect to the second wing (72) of the electronic circuit board support (68).

8. Device for supporting and connecting electronic circuit boards (50) according to one of the preceding claims, **characterized in that** the heat exchange zone or zones (104) is or are adjacent to at least one groove (82) receiving an electronic circuit board (50) equipped with a heat pipe (64).
